# EUROPEAN PATENT APPLICATION

(11) **EP 4 764 532 A1**
(43) Date of publication of application: **24.06.2026**
(21) Application number: 25816138.9
(22) Date of filing: 06.03.2025
(51) Int. Cl.: G01R 31/382, G01R 31/392, G01R 31/396, G01R 19/12, G01R 19/165

(54) **BATTERY DIAGNOSIS APPARATUS AND BATTERY DIAGNOSIS METHOD**

(30) Priority: 31.05.2024 KR 20240071643
(71) Applicant: LG Energy Solution, Ltd., Seoul 07335 (KR)
(72) Inventor: CHOI, Hyun-Jun, Daejeon 34122 (KR); KIM, Tae-Hyeon, Daejeon 34122 (KR); KIM, Hye-Yeong, Daejeon 34122 (KR)
(74) Representative: Goddar, Heinz J.
(86) International application number: PCT/KR2025/003011
(87) International publication number: WO 2025/249720

(57) **Abstract**

A battery diagnosis apparatus according to the present disclosure includes a profile obtaining unit configured to obtain a profile representing a corresponding relationship between a plurality of SOC sections of a battery and a voltage change value of each SOC section; and a control unit configured to determine a target SOC based on a result of comparing the voltage change value and a preset reference change value in each of the plurality of SOC sections, and to diagnose a state of the battery based on a result of comparing the target SOC and a preset reference SOC.

## Description

### TECHNICAL FIELD

The present disclosure relates to a battery diagnosis apparatus and method.

This application is based on and claims priority from Korean Patent Application No. 10-2024-0071643, filed on May 31, 2024, with the Korean Intellectual Property Office, the disclosure of which is incorporated herein in its entirety by reference.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Although much research is being conducted on these batteries in terms of high capacity and high density, improving lifespan and safety is also important. In order to improve battery safety, a technology that accurately diagnoses the current state of the battery is required.

Batteries gradually deteriorate when they are repeatedly charged and discharged, and changes in cell balance are one of the causes of battery deterioration. A change in cell balance refers to a phenomenon in which the positive electrode potential and the negative electrode potential at the charge or discharge start point of a battery are different from the positive electrode potential and the negative electrode potential in the BOL (Beginning of Life) state. In addition, one of the causes of cell balance changes is the loss of available lithium ions due to repeated use of the battery.

If the cell balance changes, problems may arise in terms of the safety and capacity of the battery. For example, an increase in the positive electrode potential may cause problems such as structural collapse of the positive electrode and side reactions with the electrolyte. In addition, an increase in the negative electrode potential may cause problems such as a decrease in the charge termination capacity. Therefore, in order to use the battery safely and maintain a high capacity retention rate of the battery, it is necessary to diagnose the state of the battery related to the cell balance change.

### DISCLOSURE

### Technical Problem

The present disclosure is designed to solve the problems of the related art, and therefore the present disclosure is directed to providing a battery diagnosis apparatus and method for diagnosing the state of a battery related to changes in cell balance.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery diagnosis apparatus according to one aspect of the present disclosure comprises: a profile obtaining unit configured to obtain a profile representing a corresponding relationship between a plurality of SOC sections of a battery and a voltage change value of each SOC section; and a control unit configured to determine a target SOC based on a result of comparing the voltage change value and a preset reference change value in each of the plurality of SOC sections, and to diagnose a state of the battery based on a result of comparing the target SOC and a preset reference SOC.

The control unit may be configured to diagnose the state of the battery as a normal state when the target SOC is greater than or equal to the reference SOC, and the control unit may be configured to diagnose the state of the battery as an abnormal state when the target SOC is less than the reference SOC.

The profile may be a profile configured to represent the corresponding relationship between the plurality of SOC sections distinguished for each of a plurality of SOCs and the voltage change value of each SOC section.

The control unit may be configured to determine a target section among the plurality of SOC sections in which the voltage change value exceeds the reference change value, calculate a section value of the determined target section, and determine the calculated section value as the target SOC.

When a plurality of target sections are determined, the control unit may be configured to determine a maximum value among the determined plurality of section values as the target SOC.

The reference SOC may be a SOC determined as one of at least one target SOC calculated at a previous diagnosis point.

The reference SOC may be determined as a minimum value among the at least one target SOC.

A battery pack according to another aspect of the present disclosure comprises the battery diagnosis apparatus according to one aspect of the present disclosure.

A vehicle according to still another aspect of the present disclosure comprises the battery diagnosis apparatus according to one aspect of the present disclosure.

A battery diagnosis method according to still another aspect of the present disclosure may comprise: a profile obtaining step of obtaining a profile representing a corresponding relationship between a plurality of SOC sections of a battery and a voltage change value of each SOC section; a target SOC determining step of determining a target SOC based on a result of comparing the voltage change value and a preset reference change value in each of the plurality of SOC sections; a comparing step of comparing the target SOC and a preset reference SOC; and a diagnosing step of diagnose a state of the battery based on the comparison result of the comparing step.

### Advantageous Effects

According to one aspect of the present disclosure, the state of the battery related to the change in cell balance may be diagnosed based on the change pattern of the target SOC section according to the increase in the charge and discharge cycle of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating a battery diagnosis apparatus according to an embodiment of the present disclosure.
FIG. 2 is a drawing schematically illustrating a profile according to an embodiment of the present disclosure.
FIG. 3 is a drawing schematically illustrating a plurality of profiles according to an embodiment of the present disclosure.
FIG. 4 is a drawing illustrating an exemplary configuration of a battery pack including the battery diagnosis apparatus according to an embodiment of the present disclosure.
FIG. 5 is a drawing schematically illustrating a vehicle according to still another embodiment of the present disclosure.
FIG. 6 is a drawing schematically illustrating a battery diagnosis method according to still another embodiment of the present disclosure.

### BEST MODE

Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a most preferred example for the purpose of illustrations only, not intended to limit the scope of the disclosure, so it should be understood that other equivalents and modifications could be made thereto without departing from the scope of the disclosure.

In addition, when explaining the present disclosure, if it is judged that the detailed description of the related known structure or function may obscure the main point of the present disclosure, the detailed description will be omitted.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the attached drawings.

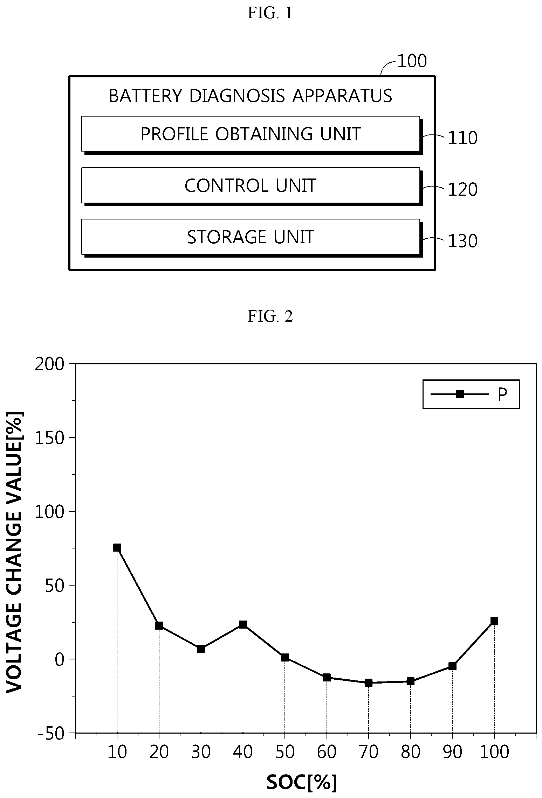

FIG. 1 is a diagram schematically illustrating a battery diagnosis apparatus 100 according to an embodiment of the present disclosure.

Referring to FIG. 1, a battery diagnosis apparatus 100 may include a profile obtaining unit 110 and a control unit 120. The battery diagnosis apparatus 100 may further include a storage unit 130.

The battery diagnosis apparatus 100 is provided to diagnose the state of a battery. Depending on the embodiment, the battery diagnosis apparatus 100 may be configured to organically link with other configurations or modules/devices, etc., to generate and output diagnostic data for the battery.

Here, the battery refers to an independent cell that has a negative electrode terminal and a positive electrode terminal and is physically separable. As an example, a lithium-ion cell or a lithium polymer cell may be considered a battery. Additionally, the type of battery may be cylindrical type, prismatic type, or pouch type. In addition, the battery may mean a battery bank, a battery module, or a battery pack in which a plurality of cells are connected in series and/or parallel. Hereinafter, for convenience of explanation, the battery is explained as meaning one independent cell.

The profile obtaining unit 110 may be configured to obtain a profile representing a corresponding relationship between a plurality of SOC sections of a battery and a voltage change value of each SOC section.

FIG. 2 is a drawing schematically illustrating a profile P according to an embodiment of the present disclosure.

In the embodiment of FIG. 2, the horizontal axis (X-axis) represents SOC (State of Charge, %), and the vertical axis (Y-axis) represents voltage change value (%). In addition, in FIG. 2, for convenience of explanation, all of a plurality of points representing the corresponding relationship between a plurality of SOC sections and a voltage change value are drawn to be connected.

Specifically, the profile P is a profile that represents the corresponding relationship between the plurality of SOC sections distinguished for each of a plurality of SOCs and the voltage change value of each SOC section.

The entire SOC section of the battery may be divided into a plurality of SOC sections according to a predetermined condition.

In one embodiment, the entire SOC section may be divided into a plurality of SOC sections at regular intervals.

FIG. 2 is a drawing illustrating an embodiment in which the entire SOC section (SOC 0% to SOC 100%) is divided into 10 SOC sections with a regular interval of 10%. That is, the entire SOC section may be divided into a SOC 0 to 10% section, a SOC 10 to 20% section, a SOC 20 to 30% section, a SOC 30 to 40% section, a SOC 40 to 50% section, a SOC 50 to 60% section, a SOC 60 to 70% section, a SOC 70 to 80% section, a SOC 80 to 90% section, and a SOC 90 to 100% section.

In another embodiment, the entire SOC section may be divided into a plurality of SOC sections such that the size of each SOC section decreases as the SOC increases. In this case, since the size of the SOC section is relatively small for the high SOC section, more precise diagnosis is possible for a battery with a small voltage change in the high SOC section.

For example, the entire SOC section can be divided into a SOC 0 to 50% section, a SOC 50 to 75% section, a SOC 75 to 85% section, a SOC 85 to 90% section, a SOC 90 to 94% section, a SOC 94 to 97% section, a SOC 97 to 99% section, and a SOC 99 to 100% section.

In another embodiment, the entire SOC section may be divided into a plurality of SOC sections such that the size of the SOC section increases as the SOC increases. In this case, since the size of the SOC section is relatively small for the low SOC section, more precise diagnosis is possible for a battery with a small voltage change in the low SOC section.

For example, the entire SOC section may be divided into a SOC 0 to 3% section, a SOC 3 to 8% section, a SOC 8 to 18% section, a SOC 18 to 40% section, a SOC 40 to 60% section, and a SOC 60 to 100% section.

The voltage change value may be calculated based on the voltage difference between the voltage corresponding to the upper limit SOC of the corresponding SOC section and the voltage corresponding to the lower limit SOC of the corresponding SOC section.

For example, the voltage difference obtained by subtracting the voltage corresponding to the lower limit SOC of the corresponding SOC section from the voltage corresponding to the upper limit SOC of the corresponding SOC section may be calculated as the voltage change value.

As another example, a voltage change value may be calculated based on the difference between the voltage difference and a preset initial voltage difference. Here, the initial voltage difference may mean a voltage difference obtained when the battery is in a BOL state. In addition, the initial voltage difference may be preset to correspond to each of a plurality of SOC sections. Specifically, the voltage difference between the voltage corresponding to the upper limit SOC of the corresponding SOC section and the voltage corresponding to the lower limit SOC of the corresponding SOC section may be calculated. In addition, a value obtained by dividing the difference between the calculated voltage difference and the initial voltage difference by the initial voltage difference may be calculated as a voltage change value.

In the embodiment of FIG. 2, the voltage change value is calculated by dividing the difference between the voltage difference (upper limit voltage - lower limit voltage) in the corresponding SOC section and the initial voltage difference by the initial voltage difference. That is, the voltage change value for the corresponding SOC section may be calculated according to the formula "{(upper limit voltage - lower limit voltage) - initial voltage difference} ÷ initial voltage difference × 100".

Meanwhile, FIG. 2 is a diagram showing the voltage change value of each SOC section in relation to the upper limit value of the corresponding SOC section. For example, the voltage change value of the SOC 0 to 10% section is shown in relation to SOC 10%. Therefore, it may be confirmed that the SOC at the point indicated by "■" in FIG. 2 is the upper limit value of the plurality of SOC sections.

In this specification, obtaining any data or information should be understood to mean reception from an external source through a communication means, input from a user, etc. through an input means, or creation through execution of a program, etc.

For example, the profile obtaining unit 110 may receive a profile from the outside. That is, the profile obtaining unit 110 may receive a profile by being connected to the outside by wire and/or wirelessly. For example, the profile obtaining unit 110 may receive a profile from the outside through a wired communication method such as CAN (Controller Area Network) communication or CAN-FD (CAN with Flexible Data rate) communication. As another example, the profile obtaining unit 110 may receive a profile from the outside through a wireless communication method such as Zigbee, Bluetooth, Wi-Fi, WFD (Wi-Fi Direct), UWB (Ultra-wideband), or mobile communication. Of course, as long as it supports communication between the profile obtaining unit 110 and the outside, the type of the communication protocol is not particularly limited.

As another example, the profile obtaining unit 110 may receive battery information about the voltage and current of the battery. Then, the profile obtaining unit 110 may generate a profile based on the received battery information.

Specifically, the profile obtaining unit 110 may estimate SOC based on the received battery information. The SOC may be calculated through various techniques such as current integration, an equivalent circuit model, and a Kalman filter. The profile obtaining unit 110 may determine a plurality of SOC sections based on the estimated SOC, and calculate a voltage change value corresponding to each SOC section. In addition, the profile obtaining unit 110 may generate a profile by recording the plurality of SOC sections and the plurality of voltage change values to be associated with each other.

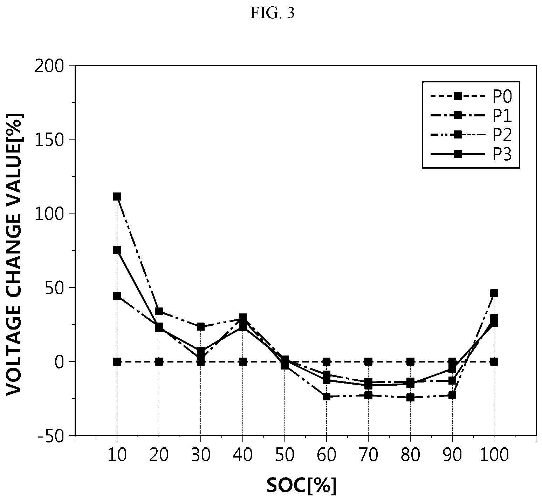

FIG. 3 is a drawing schematically illustrating a plurality of profiles P0, P1, P2, P3 according to an embodiment of the present disclosure. The initial profile P0 and the first to third profiles P1, P2, P3 are profiles obtained by repeating charge and discharge for the same battery. In addition, the initial profile P0 and the first to third profiles P1, P2, P3 are profiles obtained in different charge and discharge cycles. The initial profile P0 is a profile obtained when the battery is in a BOL state. The first profile P1 is a profile obtained when the charge and discharge cycle of the battery is 200 cycles (corresponding to the first diagnosis point). The second profile P2 is a profile obtained when the charge and discharge cycle of the battery is 400 cycles (corresponding to the second diagnosis point). The third profile P3 is a profile obtained when the charge and discharge cycle of the battery is 600 cycles (corresponding to the third diagnosis point). Meanwhile, the third profile P3 according to the embodiment of FIG. 3 may be the same profile as the profile P according to the embodiment of FIG. 2.

The control unit 120 may be configured to determine a target SOC based on the result of comparing the voltage change value and a preset reference change value in each of the plurality of SOC sections. That is, the control unit 120 may determine one target SOC for one profile.

The reference change value may be preset for each of the plurality of SOC sections. For example, the reference change value may be preset based on a reference profile obtained at a previous diagnosis point. Preferably, when there are a plurality of previous diagnosis points, the reference change value may be preset based on a reference profile obtained at a most recent diagnosis point among the previous diagnosis points. In addition, the reference change value may be preset to correspond to the voltage change value. That is, the reference change value may be preset to a value calculated in the same manner as the voltage change value.

Specifically, the reference change value may be preset based on the voltage difference between the voltage corresponding to the upper limit SOC of the plurality of SOC sections and the voltage corresponding to the lower limit SOC of the plurality of SOC sections.

For example, the voltage difference obtained by subtracting the voltage corresponding to the lower limit SOC of the corresponding SOC section from the voltage corresponding to the upper limit SOC of the corresponding SOC section may be preset as the reference change value.

As another example, a reference change value may be preset based on the difference between the voltage difference and a preset initial voltage difference. Here, the initial voltage difference may mean a voltage difference obtained when the battery is in a BOL state. In addition, the initial voltage difference may be preset to correspond to each of the plurality of SOC sections. Specifically, a value obtained by dividing the difference between the voltage difference between the voltage corresponding to the upper limit SOC of the corresponding SOC section and the voltage corresponding to the lower limit SOC of the corresponding SOC section and the initial voltage difference by the initial voltage difference may be preset as the reference change value.

If a previous diagnosis point does not exist, the reference SOCs corresponding to the plurality of SOC sections may all be preset to 0. That is, the initial value of the reference SOC may be preset to 0.

The control unit 120 may compare the voltage change value in each of the plurality of SOC sections with a reference change value. Specifically, the control unit 120 may compare the magnitude of the voltage change value in each SOC section with the reference change value.

For example, the control unit 120 may compare a voltage change value corresponding to a SOC 90 to 100% section at a diagnosis point with a voltage change value corresponding to a SOC 90 to 100% section at a previous diagnosis point (i.e., a reference change value).

The control unit 120 may be configured to determine a target section among the plurality of SOC sections in which the voltage change value exceeds the reference change value.

Specifically, the control unit 120 may compare the voltage change value corresponding to each of the plurality of SOC sections with a reference change value. For example, the control unit 120 may compare the magnitude of the voltage change value corresponding to each of the plurality of SOC sections with the reference change value. The control unit 120 may determine the SOC section in which the voltage change value exceeds the reference change value as the target section.

In the embodiment of FIG. 3, the voltage change value may be determined based on the third profile P3. In this case, the reference change value may be preset based on the second profile P2. That is, the voltage change value may be determined based on the third profile P3 obtained at the third diagnosis point. In addition, the reference change value may be determined based on the second profile P2 obtained at the second diagnosis point. That is, the voltage change value may be determined based on the profile at the n-th diagnosis point, and the reference change value may be determined based on the profile at the n-1-th diagnosis point.

The control unit 120 may compare the voltage change value in each SOC section with the reference change value.

Specifically, the control unit 120 may compare the magnitude between the voltage change value in each SOC section and the reference change value.

Referring to FIG. 3, the SOC sections where the voltage change value exceeds the reference change value are the SOC 40 to 50% section, the SOC 50 to 60% section, the SOC 60 to 70% section, the SOC 70 to 80% section, and the SOC 80 to 90% section. Therefore, the control unit 120 may determine the SOC 40 to 50% section, the SOC 50 to 60% section, the SOC 60 to 70% section, the SOC 70 to 80% section, and the SOC 80 to 90% section as target section.

The control unit 120 may be configured to calculate a section value of the determined target section.

Here, the section value is a value representing the corresponding target section and may be calculated based on a plurality of SOCs included in the target section. For example, the section value may be calculated as a maximum value, a minimum value, an average value, or a median value of the target section. Meanwhile, if the section value may be calculated in the same manner during the diagnosis process by the battery diagnosis apparatus 100, it should be noted that the value is not limited to the maximum value, the minimum value, the average value, or the median value.

In the embodiment of FIG. 3, the control unit 120 may calculate the maximum value among the SOCs included in the target section as the section value. That is, the control unit 120 may calculate SOC 50%, SOC 60%, SOC 70%, SOC 80%, and SOC 90% as the section value.

The control unit 120 may be configured to determine the calculated section value as the target SOC.

If a plurality of target sections are determined, the control unit 120 may be configured to determine the maximum value among the determined plurality of section values as the target SOC.

In the embodiment of FIG. 3, since there are a plurality of target sections, the control unit 120 may determine SOC 90%, which is the maximum value among the calculated plurality of section values, as the target SOC.

The control unit 120 may be configured to diagnose the state of the battery based on the result of comparing the target SOC and a preset reference SOC.

Here, the reference SOC may be preset to one of the at least one target SOC calculated at a previous diagnosis point.

If the previous diagnosis point does not exist, the reference SOC may represent the initial value. The initial value of the reference SOC may be preset to the maximum value among the section values. That is, at the first diagnosis point, the reference SOC may be preset to the maximum value among the section values.

Preferably, the reference SOC may be determined as the minimum value among the at least one target SOC calculated at a previous diagnosis point.

Specifically, if there is one target SOC calculated at a previous diagnosis point, the target SOC may be determined as a reference SOC. If two or more target SOCs calculated at a previous diagnosis point are all the same, the target SOC may be determined as a reference SOC. Conversely, if two or more target SOCs calculated at a previous diagnosis point are different from each other, the minimum value among the two or more calculated target SOCs may be determined as a reference SOC.

In the embodiment of FIG. 3, the diagnosis points prior to the third diagnosis point, which is the current diagnosis point, are the first diagnosis point and the second diagnosis point. The reference SOC may be preset as either the target SOC calculated at the first diagnosis point or the target SOC calculated at the second diagnosis point. Preferably, the reference SOC may be determined as the minimum value among the target SOC calculated at the first diagnosis point and the target SOC calculated at the second diagnosis point. As described above, the target SOC at the previous diagnosis point may be set based on the comparison result between the voltage change value corresponding to each SOC section and the initial value of the reference SOC.

Specifically, when comparing the first profile P1 and the initial profile P0, the SOC 0 to 10% section, the SOC 10 to 20% section, the SOC 20 to 30% section, the SOC 30 to 40% section, and the SOC 90 to 100% section may be determined as target sections, and SOC 10%, SOC 20%, SOC 30%, SOC 40%, and SOC 100% may be determined as section values. And, among the determined plurality of section values, the maximum value, SOC 100%, may be determined as the target SOC at the first diagnosis point.

Next, when comparing the second profile P2 with the first profile P1, the SOC 0 to 10% section, the SOC 10 to 20% section, the SOC 20 to 30% section, and the SOC 90 to 100% section may be determined as target sections, and SOC 10%, SOC 20%, SOC 30%, and SOC 100% may be determined as section values. And, among the determined plurality of section values, the maximum value, SOC 100%, may be determined as the target SOC at the second diagnosis point.

Therefore, since the target SOC calculated at the diagnosis points (first diagnosis point and second diagnosis point) prior to the third diagnosis point is equal to SOC 100%, the reference SOC may be preset to SOC 100%.

The control unit 120 may diagnose the state of the battery related to cell balance as an abnormal state or a normal state based on the result of comparing the magnitude of the target SOC and the reference SOC.

If the target SOC is greater than or equal to the reference SOC, the control unit 120 may be configured to diagnose the state of the battery as a normal state. Conversely, if the target SOC is less than the reference SOC, the control unit 120 may be configured to diagnose the state of the battery as an abnormal state.

In the embodiment of FIG. 3, since the target SOC (90%) at the third diagnosis point is less than the reference SOC (100%), the control unit 120 may diagnose the state of the battery as an abnormal state.

Here, an abnormal state means a state in which the battery is degraded and the cell balance is different from the BOL state. A change in the cell balance means a case in which the potential of the positive electrode and the negative electrode at the start of charge or discharge is different from the potential of the positive electrode and the negative electrode at the BOL state. Specifically, if the potential of the positive electrode at the start of charge or discharge is different from the potential of the positive electrode at the BOL state, it may be determined that the cell balance has changed. Alternatively, if the potential of the negative electrode at the start of charge or discharge is different from the potential of the negative electrode at the BOL state, it may be determined that the cell balance has changed. Alternatively, if the potential of the positive electrode and the potential of the negative electrode at the start of charge or discharge are different from the potential of the positive electrode and the potential of the negative electrode at the BOL state, it may be determined that the cell balance has changed.

If the charge and discharge voltage range of the battery is maintained constant, the change in the positive electrode potential and the change in the negative electrode potential occur together. Here, the charge and discharge voltage range includes the charge upper limit voltage and the discharge lower limit voltage. The charge upper limit voltage is a voltage preset to terminate the charging of the battery, and may be preset in consideration of the characteristics of the battery. The discharge lower limit voltage is a voltage preset to terminate the discharging of the battery, and may be preset in consideration of the characteristics of the battery.

For example, it is assumed that the discharge lower limit voltage of the battery is preset to 2.5 V, and the positive electrode potential is 3.0 V and the negative electrode potential is 0.5 V in the BOL state. If the battery degrades and the positive electrode potential increases to 3.2 V, the negative electrode potential may also increase to 0.7 V. This is because the potential difference between the positive electrode potential and the negative electrode potential (3.2 - 0.7 V) is maintained at 2.5 V. Similarly, it may be expressed that if the negative electrode potential increases to 0.7 V, the positive electrode potential also increases to 3.2 V.

If the cell balance changes, problems may arise in terms of the safety and capacity of the battery. For example, an increase in the positive electrode potential may cause problems such as structural collapse of the positive electrode and side reactions with the electrolyte. In addition, an increase in the negative electrode potential may cause problems such as a decrease in the charge termination capacity. Therefore, in order to use the battery safely and maintain a high capacity retention rate of the battery, it is necessary to diagnose the state of the battery related to the cell balance change.

The inventor of the present application recognized that the target SOC section shows a tendency to move toward a low SOC direction as the cell balance of the battery changes. That is, the inventor of the present application recognized that, when comparing the voltage change value and the reference change value for each SOC section, the target SOC section whose voltage change value exceeds the reference change value shows a tendency to move toward a low SOC direction as the battery deteriorates. Therefore, according to an embodiment of the present disclosure, if the tendency of the change in the target SOC section according to an increase in the charge and discharge cycle of the battery is identified, the state of the battery related to the cell balance change may be diagnosed.

Meanwhile, the control unit 120 included in the battery diagnosis apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the battery diagnosis apparatus 100 may further include a storage unit 130. The storage unit 130 may store data necessary for operation and function of each component of the battery diagnosis apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

Specifically, the storage unit 130 may store information necessary for the control unit 120 to diagnose the state of the battery. For example, the storage unit 130 may store a profile, an initial voltage difference, a reference change value, a reference SOC, etc. In addition, the control unit 120 may access the storage unit 130 to obtain information necessary for diagnosing the state of the battery. For example, the profile obtained by the profile obtaining unit 110 is stored in the storage unit 130, and the control unit 120 may access the storage unit 130 to obtain the stored profile.

The battery diagnosis apparatus 100 according to the present disclosure may be applied to a battery management system (BMS). That is, the BMS according to the present disclosure may include the battery diagnosis apparatus 100 described above. In this configuration, at least some of components of the battery diagnosis apparatus 100 may be implemented by supplementing or adding functions of the components included in a conventional BMS. For example, the profile obtaining unit 110, the control unit 120 and the storage unit 130 of the battery diagnosis apparatus 100 may be implemented as components of the BMS.

The battery diagnosis apparatus 100 according to the present disclosure may be provided in the battery pack. That is, the battery pack 10 according to the present disclosure may include the above-described battery diagnosis apparatus 100 and at least one battery cell. Additionally, the battery pack may further include electrical components (relays, fuses, etc.) and a case.

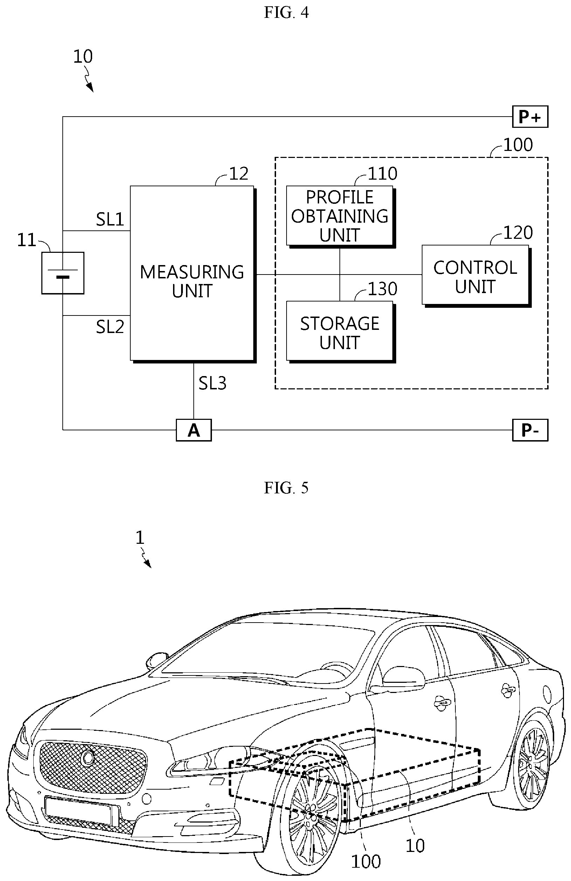

FIG. 4 is a drawing illustrating an exemplary configuration of a battery pack 10 including the battery diagnosis apparatus 100 according to an embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive terminal of the battery 11 through the first sensing line SL1, and to the negative terminal of the battery 11 through the second sensing line SL2. The measuring unit 12 may measure the voltage of the battery 11 based on the voltage measured from each of the first sensing line SL1 and the second sensing line SL2.

In addition, the measuring unit 12 may be connected to the current measurement unit A through the third sensing line SL3. For example, the current measurement unit A may be an ammeter or shunt resistor that may measure the charging current and discharging current of the battery 11. The measuring unit 12 may calculate the charging amount by measuring the charging current of the battery 11 through the third sensing line SL3. Additionally, the measuring unit 12 may calculate the discharging amount by measuring the discharging current of the battery 11 through the third sensing line SL3.

One end of a load (not shown) may be connected to the positive electrode terminal P+ of the battery pack 10, and the other end may be connected to the negative electrode terminal P- of the battery pack 10. Therefore, the positive electrode terminal of the battery 11, the positive electrode terminal P+ of the battery pack 10, the load, the negative electrode terminal P- of the battery pack 10, and the negative electrode terminal of the battery 11 may be electrically connected.

For example, the load may be a charging device that supplies power to the battery 11, or a motor, etc. of an electric vehicle that receives power from the battery 11.

FIG. 5 is a drawing schematically illustrating a vehicle 1 according to still another embodiment of the present disclosure.

Referring to FIG. 5, the battery pack 10 according to an embodiment of the present disclosure may be included in the vehicle 1 such as an electric vehicle (EV) or a hybrid vehicle (HV). Here, the battery pack 10 described above may be applied to the battery pack 10. Additionally, the battery pack 10 may drive the vehicle 1 by supplying power to the motor through an inverter provided in the vehicle 1. Here, the battery pack 10 may include the battery diagnosis apparatus 100. That is, the vehicle 1 may include the battery diagnosis apparatus 100. In this case, the battery diagnosis apparatus 100 may be an onboard device included in the vehicle 1.

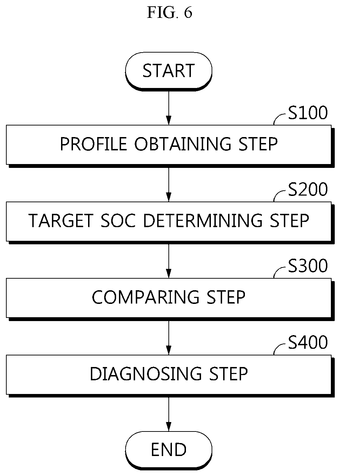

FIG. 6 is a drawing schematically illustrating a battery diagnosis method according to still another embodiment of the present disclosure.

Referring to FIG. 6, the battery diagnosis method may include a profile obtaining step (S100), a target SOC determining step (S200), a comparing step (S300), and a diagnosing step (S400).

Preferably, each step of the battery diagnosis method may be performed by the battery diagnosis apparatus 100. Hereinafter, for convenience of explanation, the content overlapping with the previously described content will be briefly described or omitted.

The profile obtaining step (S100) is a step of obtaining a profile representing a corresponding relationship between a plurality of SOC sections of a battery and a voltage change value of each SOC section, and may be performed by the profile obtaining unit 110.

The target SOC determining step (S200) is a step of determining a target SOC based on the result of comparing the voltage change value and a preset reference change value in each of the plurality of SOC sections, and may be performed by the control unit 120.

Specifically, the control unit 120 may compare the voltage change value in each of the plurality of SOC sections with a reference change value. Specifically, the control unit 120 may compare the magnitude of the voltage change value in each SOC section with the reference change value.

The control unit 120 may be configured to determine a target section among the plurality of SOC sections, in which the voltage change value exceeds the reference change value. In addition, control unit 120 may be configured to calculate a section value of the determined target section, and determine the calculated section value as a target SOC.

The section value may be calculated based on a plurality of SOCs included in the target section. For example, the section value may be calculated as a maximum value, a minimum value, or a median value of the target section. Meanwhile, if the section value may be calculated in the same manner during the diagnosis process by the battery diagnosis apparatus 100, it is noted that the value is not limited to the maximum value, the minimum value, or the median value.

If a plurality of target sections are determined, the control unit 120 may be configured to determine the maximum value among the determined plurality of section values as the target SOC.

The comparing step (S300) is a step of comparing the target SOC and a preset reference SOC, and may be performed by the control unit 120.

Specifically, the control unit 120 may compare the magnitude between the voltage change value and the reference change value in each SOC section.

The diagnosing step (S400) is a step of diagnosing the state of the battery based on the comparison result of the comparing step, and may be performed by the control unit 120.

Specifically, the control unit 120 may diagnose the state of the battery related to cell balance as an abnormal state or a normal state based on the result of comparing the magnitude of the target SOC and the reference SOC.

If the target SOC is greater than or equal to the reference SOC, the control unit 120 may be configured to diagnose the state of the battery as a normal state. Conversely, if the target SOC is less than the reference SOC, the control unit 120 may be configured to diagnose the state of the battery as an abnormal state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### [Explanation of symbols]

1: vehicle
10: battery pack
100: battery diagnosis apparatus
110: profile obtaining unit
120: control unit
130: storage unit

## Claims

1. A battery diagnosis apparatus, comprising:
a profile obtaining unit configured to obtain a profile representing a corresponding relationship between a plurality of SOC sections of a battery and a voltage change value of each SOC section; and
a control unit configured to determine a target SOC based on a result of comparing the voltage change value and a preset reference change value in each of the plurality of SOC sections, and to diagnose a state of the battery based on a result of comparing the target SOC and a preset reference SOC.

2. The battery management apparatus according to claim 1,
wherein the control unit is configured to diagnose the state of the battery as a normal state when the target SOC is greater than or equal to the reference SOC, and
wherein the control unit is configured to diagnose the state of the battery as an abnormal state when the target SOC is less than the reference SOC.

3. The battery management apparatus according to claim 1,
wherein the profile is a profile configured to represent the corresponding relationship between the plurality of SOC sections distinguished for each of a plurality of SOCs and the voltage change value of each SOC section.

4. The battery management apparatus according to claim 1,
wherein the control unit is configured to determine a target section among the plurality of SOC sections in which the voltage change value exceeds the reference change value, calculate a section value of the determined target section, and determine the calculated section value as the target SOC.

5. The battery management apparatus according to claim 4,
wherein when a plurality of target sections are determined, the control unit is configured to determine a maximum value among the determined plurality of section values as the target SOC.

6. The battery management apparatus according to claim 1,
wherein the reference SOC is a SOC determined as one of at least one target SOC calculated at a previous diagnosis point.

7. The battery management apparatus according to claim 6,
wherein the reference SOC is determined as a minimum value among the at least one target SOC.

8. A battery pack, comprising the battery diagnosis apparatus according to any one of claims 1 to 7.

9. A vehicle, comprising the battery diagnosis apparatus according to any one of claims 1 to 7.

10. A battery diagnosis method, comprising:
a profile obtaining step of obtaining a profile representing a corresponding relationship between a plurality of SOC sections of a battery and a voltage change value of each SOC section;
a target SOC determining step of determining a target SOC based on a result of comparing the voltage change value and a preset reference change value in each of the plurality of SOC sections;
a comparing step of comparing the target SOC and a preset reference SOC; and
a diagnosing step of diagnose a state of the battery based on the comparison result of the comparing step.
